# EUROPÄISCHE PATENTSCHRIFT

(11) **EP 2 810 366 B1**
(45) Veröffentlichungstag und Bekanntmachung des Hinweises auf die Patenterteilung: **30.03.2016**
(21) Anmeldenummer: 13714180.0
(22) Anmeldetag: 30.01.2013
(51) Int. Cl.: G01R 31/327, G01R 31/34, G01R 31/40, H02P 29/02, H02P 3/22, B60L 3/00

(54) **VERFAHREN UND VORRICHTUNG ZUR ÜBERWACHUNG DER KURZSCHLUSS-SCHALTEINRICHTUNG EINES DREHSTROMMOTORS**
METHOD AND APPARATUS FOR MONITORING THE SHORT-CIRCUITING SWITCHING DEVICE OF A THREE-PHASE MOTOR
PROCÉDÉ ET DISPOSITIF DE SURVEILLANCE DU SYSTÈME DE COMMANDE DE COURT-CIRCUIT D'UN MOTEUR TRIPHASÉ

(30) Priorität: 03.02.2012 AT 500232012
(43) Veröffentlichungstag der Anmeldung: 10.12.2014
(73) Patentinhaber: FTS Computertechnik GmbH, 1040 Wien (AT)
(72) Erfinder: SCHMIDT, Eric, A-2143 Großkrut (AT)
(74) Vertreter: Patentanwaltskanzlei Matschnig & Forsthuber OG
(86) Internationale Anmeldenummer: PCT/AT2013/050027
(87) Internationale Veröffentlichungsnummer: WO 2013/113051

(56) Entgegenhaltungen:
- EP-A2- 2 079 159
- JP-A- 2000 253 687
- US-A1- 2003 193 308

## Beschreibung

Die Erfindung betrifft ein Verfahren zur Überwachung der Kurzschluss-Schalteinrichtung eines Drehstrommotors für den Antrieb von Fahrzeugen, welche ausgehend von einer Gleichspannungsquelle über einen gesteuerten Umrichter gespeist wird, wobei die von einer Steuerlogik angesteuerte Kurzschluss-Schalteinrichtung mit den Eingängen des Motors verbunden ist und die Motorströme und/oder Motorspannungen gemessen werden.

Elektromotoren verschiedener Bauart - insbesondere aber Permanentmagnet-erregte Synchronmotoren - benötigen ab einer bestimmten Drehzahl einen "Drei-Phasen-Kurzschluss" - also die niederohmige Verbindung der drei Motor-Phasen - um abgeschaltet zu werden, da sie sonst ein ungewünschtes, starkes Bremsmoment erzeugen würden. Dazu verwendete Kurzschluss-Schütze, ganz allgemein die Kurzschluss-Schalteinrichtung, sind also eine Sicherheitseinrichtung, die bei Auftreten einer Abschaltbedingung ausgelöst wird und damit den sicheren Zustand des Drehstrommotors durch einen "Drei-Phasen-Kurzschluss" (und somit nahezu momentenfreies Drehen) herbeiführt.

Der Überwachung der Kurzschluss-Schalteinrichtung kommt bei Einsatz des Elektromotors in einer sicherheits-relevanten Anwendung eine besondere Rolle zu, da die Einrichtung, die den sicheren Zustand herbeiführen kann, nämlich die Kurzschluss-Schütze, in regelmäßigen Abständen auf ihre Wirksamkeit hin überprüft werden muss. Diese Überprüfungen müssen zu geeigneten Zeitpunkten durchgeführt werden, da sie den normalen Betrieb des Elektromotors unterbrechen, und sie sollen mit vorhandenen Einrichtungen einfach und verlässlich durchgeführt werden können - idealerweise beim Einschaltvorgang. Die Sicherheitsaspekte treffen im Besonderen für den Einsatz in Elektro- und Hybridfahrzeugen zu.

Gemäß der Druckschrift EP 2 079 159 A2 ist eine Antriebsvorrichtung bekannt geworden, die einen dynamischen Bremskreis aufweist, wobei eine Synchronmaschine über elektrische Widerstände Bremsleistung umsetzt und daher geeignet ist, Verzögerungsarbeit zu verrichten.

Die Druckschrift US 2003/0193308 A1 offenbart eine Testvorrichtung für Relais für den selektiven Kurzschluss von Wicklungen eines Motors.

Es ist eine Aufgabe der Erfindung, ein Verfahren und eine zugehörige Vorrichtung zu schaffen, welche die Überwachung der Kurzschluss-Schalteinrichtung für Drehstrommotoren auf eine solche Weise erlaubt, dass der Betrieb eines angetriebenen Kraftfahrzeugs nicht merklich gestört und die Sicherheit in keiner Weise gefährdet wird.

Diese Aufgabe wird mit einem Verfahren nach Anspruch 1 gelöst.

Dank der Erfindung können Kurzschlussschütze in Fahrzeugen regelmäßig und mit einfachen, ohnedies vorhandenen Mitteln überprüft werden, ohne dass eine für den Benutzer ersichtliche Beeinträchtigung des Fahrverhaltens, beispielsweise durch Entstehen unerwünschter Motormomente, auftritt oder Betriebspausen erforderlich wären. Die Auswertung wird im Allgemeinen eine Anzeige für den Fahrer und/oder ein Abspeichern und/oder Eingriffe in das Fahrmanagement des Fahrzeuges umfassen.

Eine zweckmäßige Variante der Erfindung sieht vor, dass mit Hilfe des gesteuerten Umrichters während einer Testphase Testmuster erzeugt und dem Motor zugeführt werden, wobei nur jene Leistungsschalter aktiviert werden, die zum Betrieb von zwei Motor-Phasen benötigt werden, wobei eine Phase stromlos bleibt und die Stromstärke durch die übrigen beiden Phasen während des Testmusters so bemessen ist, dass der Motor nahezu kein Drehmoment erzeugt, während des Testmusters die Ströme und/oder Spannungen an den Motor-Phasen gemessen und die Umverteilung der Ströme und/oder Spannungen bei Schließen bzw. Öffnen der Kurzschlusskontakte erfasst und ausgewertet wird.

Bei einer vorteilhaften Ausführungsform kann vorgesehen sein, dass mit Hilfe des gesteuerten Umrichters während einer Testphase Testmuster erzeugt und dem Motor zugeführt werden, wobei jede der Motor-Phasen mit so geringfügig voneinander abweichenden Schaltmustern beaufschlagt wird, dass definierte, geringe Spannungsdifferenzen zwischen den Motor-Phasen auftreten und der Motor nahezu kein Drehmoment liefert und während des Testmusters die Ströme und/oder Spannungen an den Motor-Phasen gemessen und die Umverteilung der Ströme und/oder Spannungen bei Schließen bzw. Öffnen der Kurzschlusskontakte erfasst und ausgewertet wird.

Dabei ist es empfehlenswert, wenn es bei Stillstand des Motors ausgeführt wird.

Eine andere vorteilhafte Variante des Verfahrens sieht vor, es bei rotierendem Motor, jedoch in einem Drehzahlbereich durchgeführt wird, in dem keine passive Rekuperation über die Schaltstrecken des Umrichters überbrückende Dioden auftritt.

In diesem Fall empfiehlt es sich, dass während des Betriebes jedoch zu Betriebsphasen, die kein antreibendes/bremsendes Moment seitens des Motors erfordern, die Leistungsschalter des Umrichters desaktiviert werden, die beim vorübergehenden Schließen der Kurzschlusskontakte auf Grund der an den Motorwicklungen liegenden Spannungen auftretenden Ströme gemessen werden und auf Basis der auftretenden Ströme- und oder Spannungen in den einzelnen Motor-Phasen das korrekte Öffnen/Schließen der Kurzschlusskontakte erfasst und ausgewertet wird.

Bei einer weiteren zweckmäßigen Variante kann vorgesehen sein, dass bei rotierendem, unbelasteten Motor Testmuster erzeugt und dem Motor zugeführt werden und die beim vorübergehenden Schließen der Kurzschlusskontakte auftretenden Ströme und/oder Spannungen gemessen werden sowie auf Basis dieser Messungen das korrekte Öffnen/Schließen der Kurzschlusskontakte erfasst und ausgewertet wird.

Besonders vorteilhaft ist eine Vorrichtung zur Durchführung des Verfahrens zur Überwachung der Kurzschluss-Schalteinrichtung eines Drehstrommotors für den Antrieb von Fahrzeugen, welche ausgehend von einer Gleichspannungsquelle über einen gesteuerten Umrichter gespeist wird, wobei die von einer Steuer- und Überwachungseinheit angesteuerte Kurzschluss-Schalteinrichtung mit den Eingängen des Motors verbunden ist und Strom- und/ oder Spannungssensoren zur Messung der Motorströme und/ oder Spannungen vorgesehen sind, welche entsprechende Signale an die Steuer- und Überwachungseinheit liefern, die dazu eingerichtet ist, einerseits Ansteuersignale an die Kurzschluss-Schalteinrichtung und andererseits Steuersignale an den Umrichter zu liefern, sowie auf Basis der Strom- und/oder Spannungsverteilung in den einzelnen Motor-Phasen das korrekte Öffnen/Schließen der Kurzschlusskontakte zu erfassen und auszuwerten.

Die Erfindung samt weiteren Vorteilen ist im Folgenden an Hand beispielsweiser Ausführungsformen näher erläutert, die in der Zeichnung veranschaulicht sind. In dieser zeigen:
Fig. 1 ein Blockschaltbild eines elektrischen Antriebsstranges in einem Kraftfahrzeug,
Fig. 2 den zeitlichen Ablauf einer ersten Ausführungsform des erfindungsgemäßen Verfahrens,
Fig. 3 den zeitlichen Ablauf einer ersten Ausführungsform des erfindungsgemäßen Verfahrens in einer Detaildarstellung der Einschaltsituation,
Fig. 4 ein Ablaufdiagramm betreffend das erfindungsgemäße Verfahren in seiner ersten Ausführungsform in einer Einschaltsituation,
Fig. 5 ein weiteres Ablaufdiagramm betreffend das erfindungsgemäße Verfahren in seiner ersten Ausführungsform in einer Ausschaltsituation,
Fig. 6 den zeitlichen Ablauf einer zweiten Ausführungsform des erfindungsgemäßen Verfahrens,
Fig. 7 den zeitlichen Ablauf einer zweiten Ausführungsform des erfindungsgemäßen Verfahrens in einer Detaildarstellung der Einschaltsituation,
Fig. 8 ein Ablaufdiagramm betreffend das erfindungsgemäße Verfahren in seiner zweiten Ausführungsform in einer Einschaltsituation,
Fig. 9 ein weiteres Ablaufdiagramm betreffend das erfindungsgemäße Verfahren in seiner zweiten Ausführungsform in einer Ausschaltsituation,
Fig. 10 den zeitlichen Ablauf einer dritten Ausführungsform des erfindungsgemäßen Verfahrens,

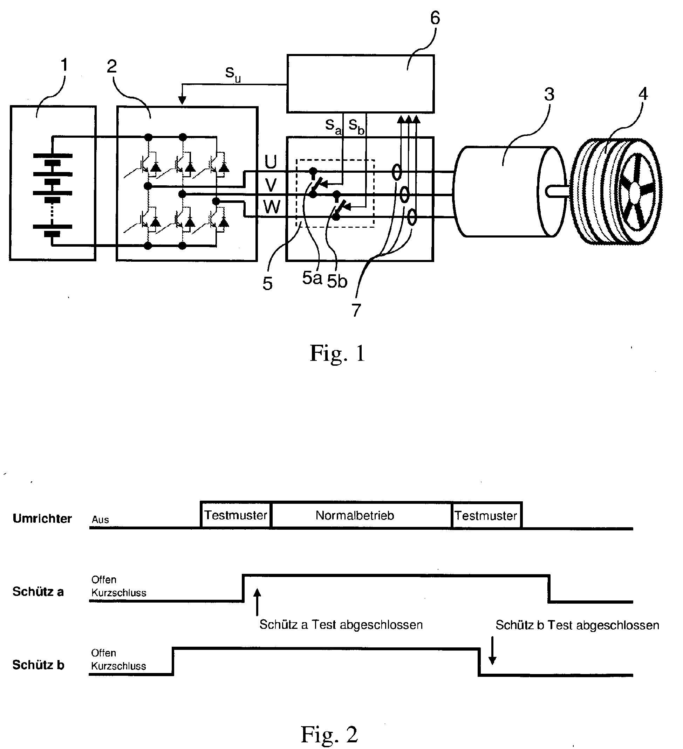

Es wird zunächst auf Fig. 1 Bezug genommen, welche eine Hochvoltbatterie 1 zeigt, die über einen gesteuerten Umrichter 2 an einen Drehstrommotor, kurz Motor 3, angeschlossen ist. Der Motor treibt beispielsweise ein Rad 4 des Fahrzeuges an. Es sollte klar sein, dass der Motor 3 im Allgemeinen nicht nur als Antriebsmotor dient, wobei er von der Batterie 1 über den Umrichter 2 gespeist wird, sondern auch als Generator im Bremsbetrieb des Fahrzeuges, wobei er dann über den Umrichter 2 die Batterie 1 lädt. Das Fahrzeug kann ein reines Elektrofahrzeug oder ein Hybridfahrzeug sein, es kann sich dabei um ein Automobil, ein Kraftrad, aber auch um ein Boot oder Luftfahrzeug handeln. Der Drehstrommotor kann hierbei sowohl direkt die Antriebsräder des Fahrzeugs antreiben bzw. bremsen oder auch über ein zwischengeschaltetes Aggregat auf die Bewegung des Fahrzeugs einwirken.

Mit den Stromzuführleitungen (Phasen U, V, W) des Motors 3 ist eine Kurzschluss-Schalteinrichtung 5 verbunden, welche zwei Schütze 5a, 5b aufweist und die von einer Steuer- und Überwachungseinheit 6 angesteuert wird. Strom- und/ oder Spannungssensoren 7 liefern entsprechende Signale an die Steuerlogik 6, welche ihrerseits Ansteuersignale sₐ, s_{b} an die beiden Schütze liefern kann und andererseits Steuersignale sᵤ an den Umrichter 2. Hier ist die gesamte Steuerung in einem Block zusammengefasst, doch ist es klar, dass der Umrichter auch eine eigene Ansteuereinheit enthalten kann, zu welcher dann eine Steuer- und Überwachungseinheit der Schalteinrichtung 5 Signale senden kann.

Ob man sämtliche Ströme und Spannungen des Drehstromsystems an den drei Motor-Phasen des Motors 3 misst, ist von Fall zu Fall verschieden, wobei oft mit zwei Stromsensoren das Auslangen gefunden werden kann, da sich in einem Drehstromsystem aus der Messung der Ströme in zwei Leitern der Strom in dem dritten Leiter ergibt.

Die Kontakte der beiden Schütze 5a, 5b sind bei eingeschaltetem Steuerstrom offen, was einen normalen Motor- bzw. Generatorbetrieb erlaubt. Bei Wegfall des Steuerstroms schließen die Kontakte in jedem Schütz je zwei Phasen des Elektromotors kurz. Es sind jedoch auch andere elektromechanische Ausführungen als die Anordnung von zwei Schützen möglich. So könnte beispielsweise - bei einer noch weiter unten beschriebenen Variante der Erfindung - ein einziger angetriebener Kontaktsteg für den Kurzschluss aller drei Phasen des Elektromotors vorgesehen sein.

Da ein direkter Kurzschluss zwischen zwei oder drei Motor-Phasen im normalen Betrieb des seitens des Umrichters 2 mit Strom gespeisten Motors 3 nicht zulässig ist und auch die im Motor 3 befindlichen Wicklungen neben einer Induktivität auch eine niederohmige Verbindung zwischen den Motor-Phasen bilden, ist eine Messung zur Erkennung ob die Kurzschluss-Schalteinrichtung 5 offen oder geschlossen ist nicht ohne Weiteres möglich. Daher wurden im Rahmen der Erfindung ein Verfahren bzw. dessen Varianten geschaffen, was nachstehend erläutert wird.

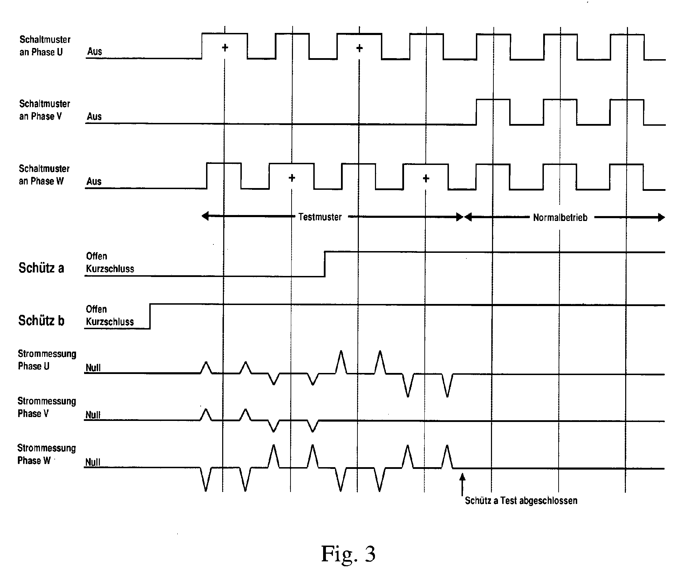

Mit der beschriebenen Vorrichtung kann ein Verfahren zur Überwachung der Kurzschluss-Schalteinrichtung wie folgt durchgeführt werden, wozu auch auf Fig. 2 verwiesen wird. Zu vereinbarten Betriebszeitpunkten, z.B. unmittelbar nach dem Einschalten oder nach Anforderung durch die Steuer- und Überwachungseinheit 6, wird ein Testmuster durch den von der Steuer- und Überwachungseinheit 6 angesteuerten Umrichter 2 erzeugt, welches von den sechs im Umrichter befindlichen Leistungsschaltern, die hier nicht näher bezeichnet sind, nur jene vier aktiviert, die zum Betrieb von zwei Phasen benötigt werden. Die eine verbleibende Phase, in Fig. 1 die "mittlere" Phase, welche mit beiden Schützen 5a, 5b verbunden ist, bleibt bei diesem Testmuster stets stromlos. Die Stromstärke durch die übrigen beiden Phasen soll während dieses Testmusters so bemessen sein, dass kein Moment am Motor 3 erzeugt wird. Dies kann beispielsweise durch rasche Stromrichtungsumkehr - wie in Fig. 3 dargestellt - oder durch einen entsprechend geringen richtungskonstanten Stromfluss erreicht werden. Während dieses Testmusters werden die Ströme und Spannungen an den drei Motor-Phasen durch die Strom- und/ oder Spannungssensoren 7 gemessen und entsprechende Signale werden der Steuer- und Überwachungseinheit 6 zugeführt. Diese detektiert die Umverteilung der Ströme bei Schließen bzw. Öffnen jeweils eines Schützes 5a bzw. 5b. Sind beide Schütze offen, so wird die Stromverteilung [+1; 0; -1] gemessen. Die Summe der drei Ströme muss gemäß Kirchhoff'scher Knotenregel natürlich stets Null sein. Nach Schließen des einen Schützes ändert sich die Stromverteilung auf [(1-x); x; -1]. Ist der andere Schütz geschlossen (und der erste offen) ergibt sich [+1; -y; (y-1)]. Durch Vergleich der Stromverteilungen vor und nach der Schützbetätigung kann das Erreichen eines zulässigen Wertebereichs für x bzw. y (z.B.: 0.3 < x < 0.7) überprüft werden. Beide Schütze werden während dieses Testmusters niemals gleichzeitig geschlossen, da dies eine Überstrom-Erkennung im Umrichter 2 auslösen würde. Um die Anzahl der Schütz-Zyklen nicht unnötig zu erhöhen, kann auch eine Einschalt- bzw. Abschaltabfolge eingeführt werden, die zu Beginn jedes Fahrzyklus zunächst nur einen Schütz öffnet, dann das Testmuster aktiviert und dann auch den zweiten Schütz öffnet. Nach dem Motorbetrieb wird die Abschaltabfolge so gewählt, dass letztlich beide Schütze auf ihre Fähigkeit den Kurzschluss herbeizuführen, geprüft wurden. Auch kann die Reihenfolge von Fahrzyklus zu Fahrzyklus vertauscht werden.

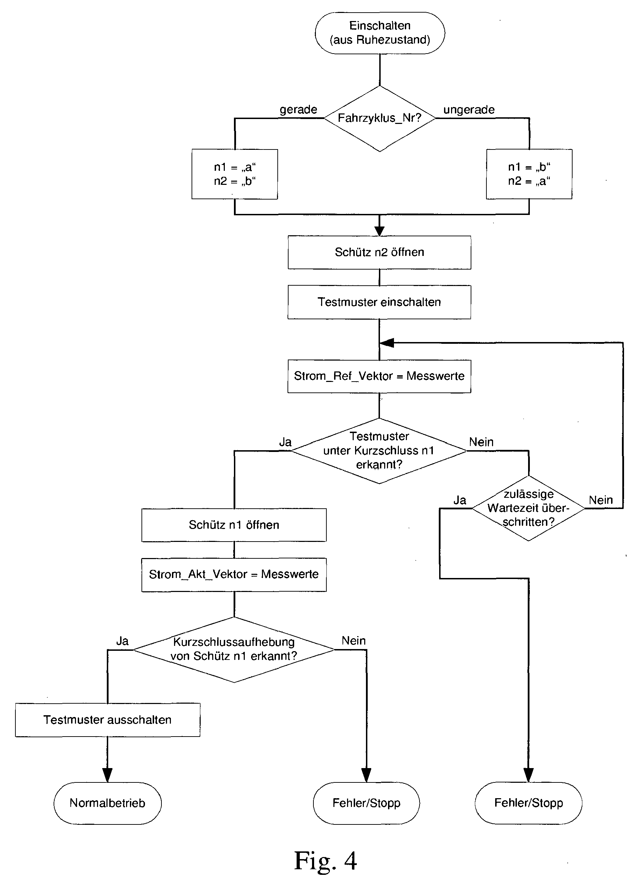

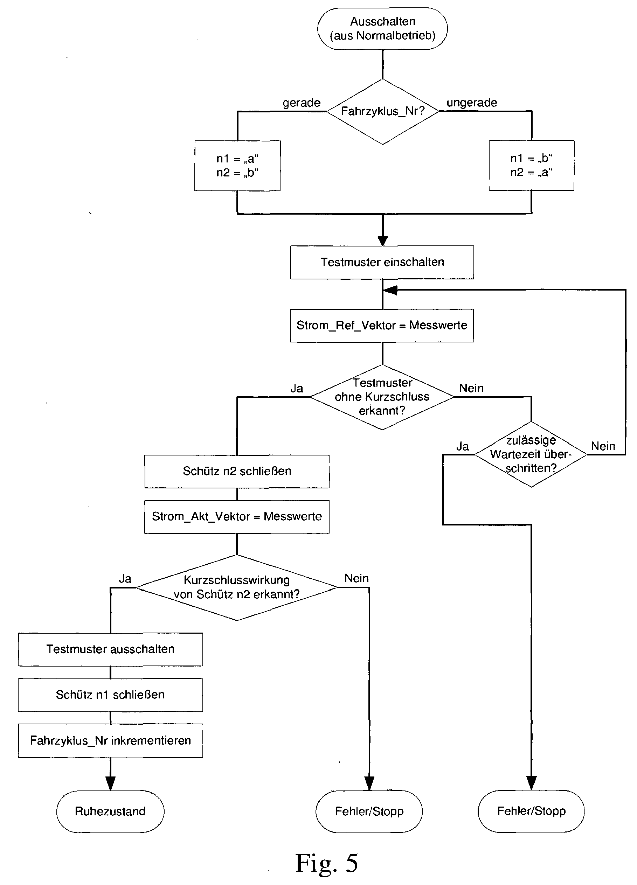

Das zuvor beschriebene Verfahren ist auch in den Ablaufdiagrammen der Fig. 4 und 5 dargestellt, wobei Fig. 4 die logische Abfolge beim Einschaltvorgang beschreibt und Fig. 5 den Abschaltvorgang ausführt.

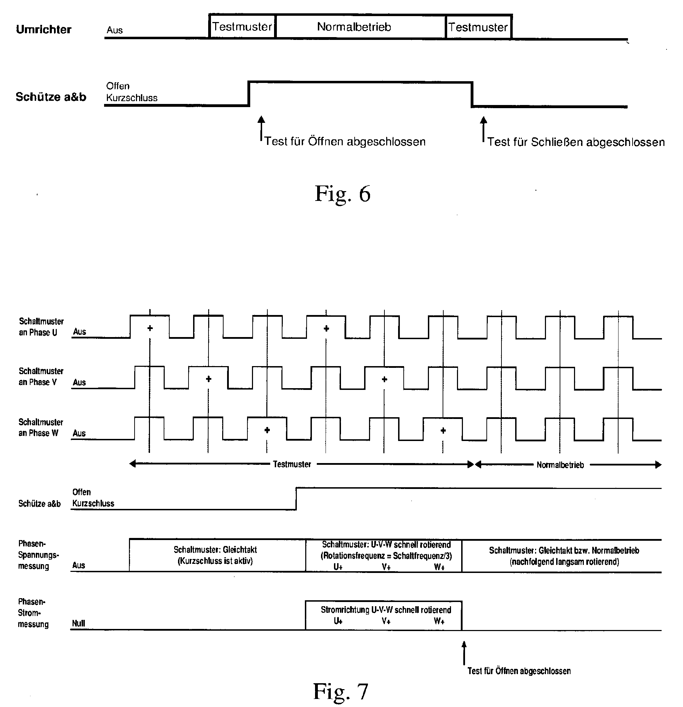

Nun wird eine zweite Ausführungsform der Erfindung unter Bezugnahme auf die Fig. 6 bis 9 erläutert, welche unter gewissen Fällen zweckmäßig sein kann, beispielsweise bei Verwendung eines Schütz mit einem einzigen Kurzschlusssteg oder wenn die Stromsensoren zwischen Umrichter 2 und Kurzschluss-Schalteinrichtung 5 - also an anderer Stelle als bei Fig. 1 dargestellt - liegen. Das Testmuster, dass bei dieser Variante vom Umrichter generiert werden muss, ist dem Normalbetrieb deutlich ähnlicher als bei der vorgenannten Ausführungsform und verwendet alle sechs im Umrichter 2 befindlichen Leistungsschalter, jedoch mit einer betriebs-untypischen, hohen Umlauffrequenz.

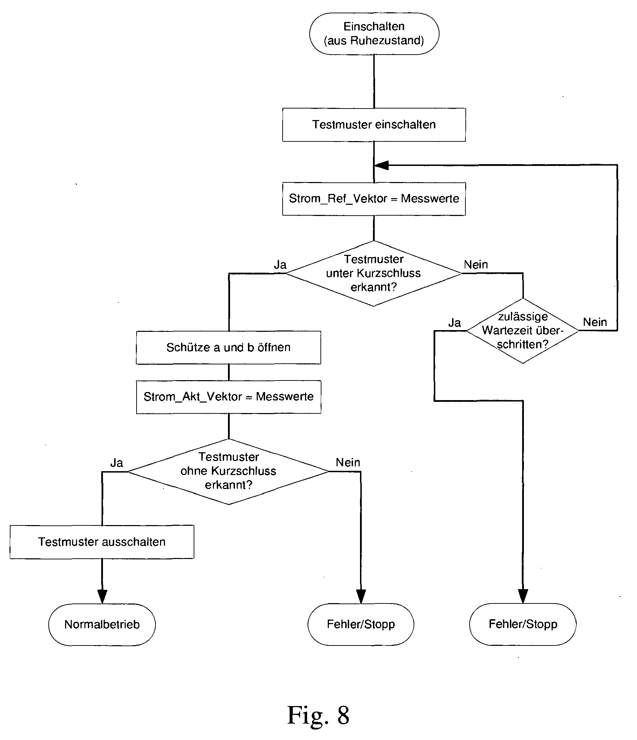

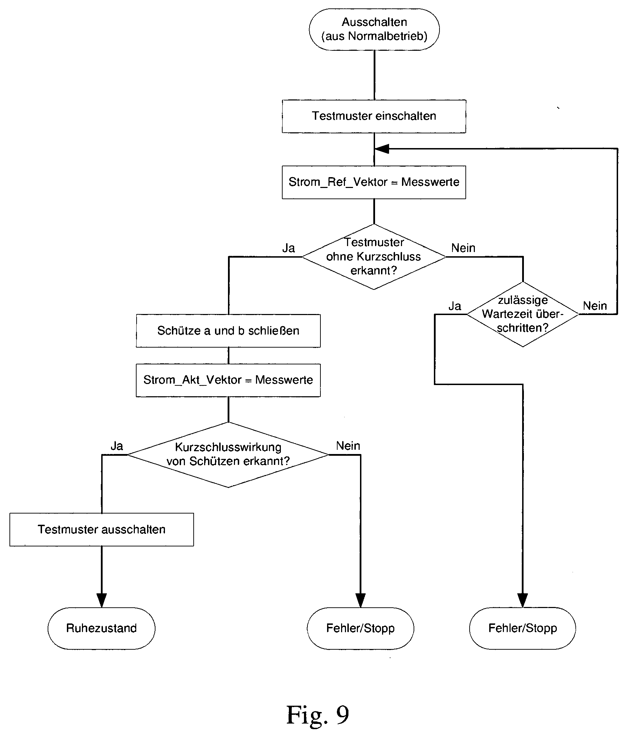

Zu vereinbarten Betriebszeitpunkten (z.B. unmittelbar nach dem Einschalten) oder nach Anforderung durch die Steuer- und Überwachungseinheit 6 wird ein Testmuster durch den Umrichter 2 erzeugt, welches die drei Phasen mit einem sehr ähnlichen Schaltmuster beaufschlagt, sodass nur geringe aber definierte Spannungsdifferenzen zwischen den Phasen auftreten. Der zeitliche Ablauf ist in Fig. 6 und 7 dargestellt, wobei Fig. 7 eine weitere Detaillierung des Einschaltvorgangs und des verwendeten Testmusters beinhaltet. Die Spannungsdifferenzen zwischen den drei Phasen werden durch geringe (in Fig.7 übertrieben dargestellte) Ansteuerdauerunterschiede bei den mit hoher Frequenz (typisch 10 kHz) erfolgenden Schaltvorgängen der Leistungsschalter erzielt. Die Stromstärke soll während dieses Testmusters so sein, dass im Mittel kein Moment am Motor erzeugt wird - dies wird durch rasche Richtungsänderungen der (an sich geringen) Spannungsdifferenzen erreicht. Während dieses Testmusters werden die Ströme und Spannungen an den drei Motor-Phasen mittels der Strom- und/oder Spannungssensoren 7 gemessen wobei durch die Steuer- und Überwachungseinheit 6 die Umverteilung der Ströme bei Schließen bzw. Öffnen eines Schützes oder auch beider Schütze 5a, 5b detektiert wird. Zur Vermeidung der ungewünschten Überstrom-Erkennung im Umrichter, dürfen die Ansteuerdauerunterschiede zwischen den Phasen nur gering sein, was wiederum nur geringe Spannungsunterschiede und auch recht kleine Stromflüsse durch den Motor verursacht. Ein definiertes Testmuster (z.B. rotierender Spannungszeiger mit definierter Umlaufrichtung und definierter Frequenz - wie in Fig. 7 dargestellt) kann aber auch bei geringen Strom- und Spannungsarnplituden gemessen werden und die erwartete Veränderung der Ströme und Spannungen bei Schließen bzw. Öffnen eines Schützes oder auch beider Schütze erkannt werden. Wie bereits ausgeführt, kann bei diesem Verfahren auch ein einzelner (drei-poliger) Schütz, der den Drei-Phasen-Kurzschluss herbeiführt, eingesetzt werden. Die Erkennung kann über die Stromsensoren alleine, eine Drei-Phasen-Spannungsmessung alleine oder auch über eine kombinierte Messung erfolgen. Die exakte Lage der Stromsensoren ist für dieses Testverfahren nicht ausschlaggebend. Um die Anzahl der Schütz-Zyklen nicht unnötig zu erhöhen, kann auch eine Einschalt- bzw. Abschaltabfolge eingeführt werden, die zu Beginn jedes Fahrzykluses zunächst nur einen Schütz öffnet, dann das Testmuster aktiviert und dann auch den zweiten Schütz öffnet. Nach dem Motorbetrieb wird die Abschaltabfolge so gewählt, dass letztlich beide Schütze auf ihre Fähigkeit den Kurzschluss herbeizuführen, geprüft wurden. Auch kann die Reihenfolge von Fahrzyklus zu Fahrzyklus vertauscht werden. Wird jedoch eine einzelne Kurzschluss-Schalteinrichtung verwendet, die einen Drei-Phasen-Kurzschluss herbeiführen kann (und somit Schütz 5a und 5 b somit nur gemeinsam betätigt werden können), so kann diese zweite Ausführungsform des erfindungsgemäßen Verfahrens dennoch zur Prüfung der Kurzschluss-Schalteinrichtung gemäß dem in Fig. 8 und Fig. 9 dargestellten Ablaufdiagramm eingesetzt werden, wobei Fig. 8 den Einschaltvorgang und Fig. 9 den Abschaltvorgang ausführt.

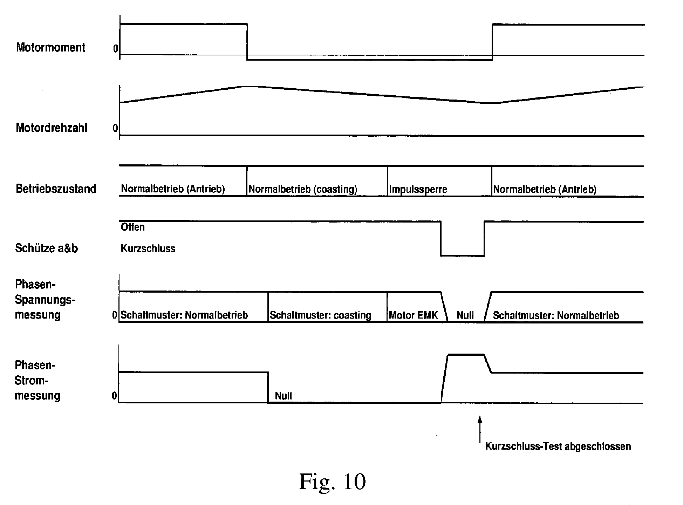

Schließlich sei eine dritte Ausführungsform des erfindungsgemäßen Verfahrens unter Bezugnahme auf die Fig. 10 erläutert.

In jenen Betriebspunkten, in denen kein antreibendes Moment vom Elektromotor angefordert wird (z.B. "coasting"), können - bei geeigneter Drehzahl - die im Umrichter liegenden Leistungsschalter alle deaktiviert werden ("Impulssperre"). Dies erzeugt kein Moment und keinen Stromfluss, sehr wohl aber den für den Elektromotor typischen Spannungsverlauf an den drei Phasen ("Motor EMK"), wobei Amplitude und Frequenz des Spannungsverlaufs drehzahlabhängig sind. Durch Schließen der beiden Kurzschluss-Schütze wird die Spannung an den Motor-Phasen schlagartig gesenkt und es treten Ströme an den Motor-Phasen auf, die gut messbar sind. Auch in diesem Betriebszustand tritt - bei geeigneter Drehzahl - kein Moment (bzw. ein akzeptierbares geringes Bremsmoment) an der Motorwelle auf. Die Wirkung der Kurzschluss-Schalteinrichtung ist also auch mit dieser Ausführung des Verfahrens über die Änderung der Ströme bzw. der Spannungen nachweisbar. Das zuletzt beschriebene Variante des erfindungsgemäßen Verfahrens ist insbesondere in jenen Systemen einsetzbar, in denen derartige Betriebspunkte mit ausreichender Häufigkeit erreicht werden, sodass die Prüfung der Kurzschluss-Schalteinrichtung 5 mit ausreichender Häufigkeit im Betreib durchgeführt werden kann. Diese dritte Ausführungsform kann auch in Kombination mit den ersten beiden Ausführungsformen eingesetzt werden. Insbesondere kann man bei einer vierten Variante vorsehen, dass bei rotierendem, unbelasteten Motor nicht die Schalter des Umrichters 2 desaktiviert werden, sondern man Testmuster erzeugt und führt sie dem Motor zu. Dabei werden die Kurzschlusskontakte vorübergehend geschlossen und wiederum die Spannungen und/oder Ströme gemessen. Auf Basis der auftretenden Ströme und/oder Spannungen in den einzelnen Phasen der Drehstromleitungen wird dann das korrekte Öffnen/Schließen der Kurzschlusskontakte erfasst und ausgegeben. Dieses Verfahren kann in geeigneten Drehzahlbereichen, die meist von dem jeweiligen Motor abhängen, durchgeführt werden.

Es soll nicht unerwähnt gelassen werden, dass die Testmuster nicht nur zur Prüfung der Kurzschlusseinrichtung sondern auch zur Feststellung der "Gesundheit" des Umrichters eingesetzt werden können, also zur Prüfung dessen korrekter Funktion. Auch Kalibriervorgänge, z.B. zur Ermittlung von unterschiedlichen Verzögerungszeiten in der Leistungselektronik des Umrichters, sind möglich, wobei die Steuer- und Überwachungseinheit 6 die Messergebnisse in geeigneter Form an den Umrichter überträgt.

## Patentansprüche

1. Verfahren zur Überwachung der Kurzschluss-Schalteinrichtung eines Drehstrommotors (3) für den Antrieb von Fahrzeugen, welche ausgehend von einer Gleichspannungsquelle (1) über einen gesteuerten Umrichter (2) gespeist wird, wobei die von einer Steuerlogik (6) angesteuerte Kurzschluss-Schalteinrichtung (5) mit den Eingängen des Motors verbunden ist und die Motorströme und/ oder Motorspannungen gemessen werden,
**dadurch gekennzeichnet, dass**
mit Hilfe des gesteuerten Umrichters (2) während einer Testphase ein vorgegebenes, von den Spannungs/Stromverläufen im Betrieb verschiedenes Testmuster erzeugt und dem Motor (3) zugeführt wird,
die Kurzschluss-Schalteinrichtung zu deren Betätigung angesteuert wird, der Strom- und/oder Spannungsverlauf beim Öffnen und Schließen von Kurzschlusskontakten während der Testphase erfasst wird und
auf Basis der Strom- und/ oder Spannungsverteilung in den einzelnen Motor-Phasen das korrekte Öffnen/Schließen der Kurzschlusskontakte erfasst und ausgewertet wird,
wobei jede der Motor-Phasen mit so geringfügig voneinander abweichenden Schaltmustern beaufschlagt wird, dass definierte, geringe Spannungsdifferenzen zwischen den Motor-Phasen auftreten und der Motor nahezu kein Drehmoment liefert und während des Testmusters die Ströme und/oder Spannungen an den Motor-Phasen gemessen und die Umverteilung der Ströme und/oder Spannungen bei Schließen bzw. Öffnen der Kurzschlusskontakte erfasst und ausgewertet wird.

2. Verfahren nach Anspruch 1, **dadurch gekennzeichnet, dass** es bei Stillstand des Motors (3) ausgeführt wird.

3. Verfahren nach Anspruch 1, **dadurch gekennzeichnet, dass** es bei rotierendem Motor (3), jedoch in einem Drehzahlbereich durchgeführt wird, in dem keine passive Rekuperation über die Schaltstrecken des Umrichters überbrückende Dioden auftritt.

4. Verfahren nach Anspruch 3, **dadurch gekennzeichnet, dass** während des Betriebes jedoch zu Betriebsphasen, die kein antreibendes/bremsendes Moment seitens des Motors erfordern, die Leistungsschalter des Umrichters deaktiviert werden, die beim vorübergehenden Schließen der Kurzschlusskontakte auf Grund der an den Motorwicklungen liegenden Spannungen auftretenden Ströme gemessen werden und auf Basis der auftretenden Ströme- und/ oder Spannungen in den einzelnen Motor-Phasen der Drehstromleitungen das korrekte Öffnen/Schließen der Kurzschlusskontakte erfasst und ausgegeben wird.

5. Verfahren nach einem der Ansprüche 3 oder 4, **dadurch gekennzeichnet, dass** bei rotierendem, unbelasteten Motor Testmuster erzeugt und dem Motor zugeführt werden und die beim vorübergehenden Schließen der Kurzschlusskontakte auftretenden Ströme und/oder Spannungen gemessen werden sowie auf Basis dieser Messungen das korrekte Öffnen/Schließen der Kurzschlusskontakte erfasst und ausgegeben wird.

6. Vorrichtung zur Durchführung des Verfahrens nach einem der Ansprüche 1 bis 5 zur Überwachung der Kurzschluss-Schalteinrichtung (5) eines Drehstrommotors (3) für den Antrieb von Fahrzeugen, welche ausgehend von einer Gleichspannungsquelle (1) über einen gesteuerten Umrichter (2) gespeist wird, wobei die von einer Steuer- und Überwachungseinheit (6) angesteuerte Kurzschluss-Schalteinrichtung mit den Eingängen des Motors verbunden ist und Strom- und/oder Spannungssensoren (7) zur Messung der Motorströme und/oder Spannungen vorgesehen sind, welche entsprechende Signale an die Steuer- und Überwachungseinheit (6) liefern, die dazu eingerichtet ist, einerseits Ansteuersignale (sₐ, s_{b}) an die Kurzschluss-Schalteinrichtung (5) und andererseits Steuersignale (sᵤ) an den Umrichter (2) zu liefern, sowie auf Basis der Strom- und/oder Spannungsverteilung in den einzelnen Motor-Phasen das korrekte Öffnen/Schließen der Kurzschlusskontakte zu erfassen und auszugeben, **dadurch gekennzeichnet, dass** mit Hilfe des gesteuerten Umrichters (2) während einer Testphase ein vorgegebenes, von den Spannungs/Stromverläufen im Betrieb verschiedenes Testmuster erzeugt und dem Motor (3) zugeführt wird, wobei jede der Motor-Phasen mit so geringfügig voneinander abweichenden Schaltmustern beaufschlagt wird, dass definierte, geringe Spannungsdifferenzen zwischen den Motor-Phasen auftreten und der Motor nahezu kein Drehmoment liefert und während des Testmusters die Ströme und/oder Spannungen an den Motor-Phasen gemessen und die Umverteilung der Ströme und/oder Spannungen bei Schließen bzw. Öffnen der Kurzschlusskontakte erfasst und ausgewertet wird.

## Claims

1. A method for monitoring the short-circuiting switching device of a three-phase motor (3) for driving vehicles, which is fed from a DC voltage source (1) via a controlled converter (2), wherein the short-circuiting switching device (5) actuated by a control logic (6) is connected to the inputs of the motor, and the motor currents and/or motor voltages are measured,
**characterised in that**
a predetermined test pattern, which is different from the voltage/current profiles during operation, is generated with the aid of the controlled converter (2) during a test phase and is supplied to the motor (3),
the short-circuiting switching device is actuated for the activation thereof, the current and/or voltage profile is detected during the test phase by opening and closing short-circuiting contacts and,
on the basis of the current and/or voltage distribution in the individual motor phases, the correct opening/closing of the short-circuiting contacts is detected and evaluated,
wherein switching patterns are applied to each of the motor phases and deviate so slightly from one another that defined, small voltage differences occur between the motor phases and the motor delivers practically no torque, and during the test pattern the currents and/or voltages across the motor phases are measured and the redistribution of the currents and/or voltages when the short-circuiting contacts are closed and opened is detected and evaluated.

2. The method according to Claim 1, **characterised in that** said method is performed during stoppage of the motor (3).

3. The method according to Claim 1, **characterised in that** the method is performed as the motor (3) rotates, but in a rotational speed range in which there is no passive regenerative braking via diodes bridging the clearances between open contacts of the converter.

4. The method according to Claim 3, **characterised in that**, during operation but during operating phases that require no driving/braking torque on the part of the motor, the circuit breakers of the converter are deactivated, the currents occurring with momentary closure of the short-circuiting contacts due to the voltages applied across the motor windings are measured, and the correct opening/closing of the short-circuiting contacts is detected and output on the basis of the occurring currents and/or voltages in the individual motor phases.

5. The method according to one of Claims 3 or 4, **characterised in that** test patterns can be produced with a rotating, unloaded motor and can be supplied to the motor, and the currents and/or voltages occurring during the momentary closure of the short-circuiting contacts can be measured, and the correct opening/closing of the short-circuiting contacts can be detected and output on the basis of these measurements.

6. An apparatus for carrying out the method according to one of Claims 1 to 5 for monitoring the short-circuiting switching device (5) of a three-phase motor (3) for driving vehicles, which is fed from a DC voltage source (1) via a controlled converter (2), wherein the short-circuiting device actuated by a control and monitoring unit (6) is connected to the inputs of the motor and current and/or voltage sensors (7) for measuring the motor currents and/or voltages are provided, which deliver corresponding signals to the control and monitoring unit (6), which is configured on the one hand to deliver actuation signals (sₐ, s_{b}) to the short-circuiting switching device (5) and on the other hand to deliver control signals (sᵤ) to the converter (2) and also to detect and to output the correct opening/closing of the short-circuiting contacts on the basis of the current and/or voltage distribution in the individual motor phases, wherein a predetermined test pattern, which is different from the voltage/current profiles during operation, is generated with the aid of the controlled converter (2) during a test phase and is supplied to the motor (3), wherein switching patterns are applied to each of the motor phases and deviate so slightly from one another that defined, small voltage differences occur between the motor phases and the motor delivers practically no torque, and during the test pattern the currents and/or voltages across the motor phases are measured and the redistribution of the currents and/or voltages when the short-circuiting contacts are closed and opened is detected and evaluated.

## Revendications

1. Procédé de surveillance du dispositif de commutation de court-circuit d'un moteur triphasé (3) pour l'entraînement de véhicules, qui est alimenté par l'intermédiaire d'un convertisseur commandé (2) à partir d'une source de tension continue (1), dans lequel le dispositif de commutation de court-circuit (5) commandé par une logique de commande (6) est relié aux entrées du moteur et les courants de moteur et/ou tensions de moteur sont mesurés,
**caractérisé par le fait que**
à l'aide du convertisseur commandé (2), pendant une phase de test, un motif de test prédéterminé, différent des progressions de tension/courant lors du fonctionnement, est généré et fourni au moteur (3),
le dispositif de commutation de court-circuit est commandé pour son actionnement, la progression de courant et/ou de tension est détectée pendant la phase de test lors de l'ouverture et de la fermeture des contacts de court-circuit et
l'ouverture/fermeture correcte des contacts de court-circuit est détectée et évaluée sur la base de la distribution de courant et/ou de tension dans les phases individuelles de moteur,
dans lequel chacune des phases de moteur est alimentée avec des motifs de commutation si légèrement différents les uns des autres que des différences de tension faibles, définies, se produisent entre les phases de moteur et le moteur ne fournit pratiquement aucun couple et, pendant le motif de test, les courants et/ou tensions sont mesurés aux phases de moteur et la distribution des courants et/ou des tensions est détectée et évaluée lors de la fermeture ou de l'ouverture des contacts de court-circuit.

2. Procédé selon la revendication 1, **caractérisé par le fait qu'**il est effectué à l'arrêt du moteur (3).

3. Procédé selon la revendication 1, **caractérisé par le fait qu'**il est effectué avec un moteur en rotation (3), néanmoins dans une plage de vitesses de rotation dans laquelle aucune récupération passive ne se produit par l'intermédiaire de diodes de pontage des trajets de commutation du convertisseur.

4. Procédé selon la revendication 3, **caractérisé par le fait qu'**au cours du fonctionnement, néanmoins à des phases de fonctionnement qui n'exigent aucun couple d'entraînement/freinage du côté du moteur, les coupe-circuit du convertisseur sont désactivés, les courants qui se produisent lors de la fermeture temporaire des contacts de court-circuit en raison des tensions se trouvant sur les enroulements de moteur sont mesurés et l'ouverture/fermeture correcte des contacts de court-circuit est détectée et délivrée en sortie sur la base des courants et/ou tensions se produisant dans les phases individuelles de moteur des lignes triphasées.

5. Procédé selon l'une des revendications 3 ou 4, **caractérisé par le fait que**, avec un moteur non chargé, en rotation, des motifs de test sont générés et fournis au moteur et les courants et/ou tensions se produisant lors de la fermeture temporaire des contacts de court-circuit sont mesurés et l'ouverture/fermeture correcte des contacts de court-circuit est détectée et délivrée en sortie sur la base de ces mesures.

6. Dispositif destiné à mettre en oeuvre le procédé selon l'une des revendications 1 à 5 de surveillance du dispositif de commutation de court-circuit (5) d'un moteur triphasé (3) pour l'entraînement de véhicules, qui est alimenté par l'intermédiaire d'un convertisseur commandé (2) à partir d'une source de tension continue (1), dans lequel le dispositif de commutation de court-circuit commandé par une unité de commande et de surveillance (6) est relié aux entrées du moteur et des capteurs de courant et/ou tension (7) sont prévus pour mesurer les courants et/ou tensions de moteur, lesquels fournissent des signaux correspondants à l'unité de commande et de surveillance (6), qui est conçue pour fournir d'une part des signaux d'entraînement (sₐ, s_{b}) au dispositif de commutation de court-circuit (5) et d'autre part des signaux de commande (sᵤ) au convertisseur (2), ainsi que pour détecter et délivrer en sortie l'ouverture/fermeture correcte des contacts de court-circuit sur la base de la distribution de courant et/ou de tension dans les phases individuelles de moteur, **caractérisé par le fait que**, avec l'aide du convertisseur commandé (2), pendant une phase de test, un motif de test prédéterminé, différent des profils de tension/courant pendant le fonctionnement, est généré et fourni au moteur (3), dans lequel chacune des phases de moteur est alimentée avec des motifs de commutation si légèrement différents les uns des autres que des différences de tension faibles, définies, se produisent entre les phases de moteur et le moteur ne fournit pratiquement aucun couple et, pendant le motif de test, les courants et/ou tensions sont mesurés aux phases de moteur et la distribution des courants et/ou tensions est détectée et évaluée lors de la fermeture ou de l'ouverture des contacts de court-circuit.
